# EUROPÄISCHE PATENTSCHRIFT

(11) **EP 0 742 898 B1**
(45) Veröffentlichungstag und Bekanntmachung des Hinweises auf die Patenterteilung: **18.06.1997**
(21) Anmeldenummer: 95907548.2
(22) Anmeldetag: 01.02.1995
(51) Int. Cl.: G01N 21/88, H05K 13/08

(54) **VORRICHTUNG ZUM ABBILDEN EINES DREIDIMENSIONALEN OBJEKTS**
DEVICE FOR IMAGING A THREE-DIMENSIONAL OBJECT
DISPOSITIF D'IMAGERIE DESTINE A UN OBJET TRIDIMENSIONNEL

(30) Priorität: 02.02.1994 DE 9401711 U; 05.08.1994 DE 9412705 U
(43) Veröffentlichungstag der Anmeldung: 20.11.1996
(73) Patentinhaber: KRATZER AUTOMATISIERUNG GMBH, 85716 Unterschleissheim (DE)
(72) Erfinder: FANDRICH, Jürgen, D-85391 Allershausen (DE); SALOMON, Werner, D-85395 Wolfersdorf (DE)
(74) Vertreter: KUHNEN, WACKER & PARTNER
(86) Internationale Anmeldenummer: DE9500132
(87) Internationale Veröffentlichungsnummer: WO9521376

(56) Entgegenhaltungen:
- WO-A-91/15104
- US-A- 4 959 898
- US-A- 5 140 643
- IBM TECHNICAL DISCLOSURE BULLETIN, Bd. 30,Nr. 4, September 1987 NEW YORK US, Seiten 1506-1508, 'OPTICAL INSPECTION/ALIGNMENT OF MULTISIDED COMPONENT CONNECTIONS'

## Beschreibung

Die vorliegende Erfindung betrifft eine Vorrichtung zum Abbilden, Untersuchen und gegebenenfalls Ausmessen von dreidimensionalen Objekten, insbesondere für die automatisierte Qualitätsprüfung von Produkten, z. B. von SMD-Bauteilen.

Aus der DE-AS-26 17 457 bzw. der US-A-4,025,201 ist eine Vorrichtung zur Prüfung von durchsichtigen axialsymmetrischen Gegenständen bekannt. Diese bekannte Vorrichtung umfaßt eine Bilddarstellungseinrichtung in Form einer Kamera, eine optische Abbildungsanordnung bestehend aus einer Mehrzahl von Spiegeln, die gleichzeitig zwei Einzelabbildungen aus unterschiedlichen Blickrichtungen des durchsichtigen, dreidimensionalen Objekts (Glasflaschen) auf die Kamera projiezieren. Eine Impulslichtquelle beleuchtet den zwischen den Spiegeln und der Impulslichtquelle angeordneten Abbildungsbereich. Die zu überprüfenden Flaschen werden mittels eines Förderbands durch den Abbildungsbereich hindurch transportiert. Nachteilig bei dieser bekannten Vorrichtung ist es, daß sie nur für durchsichtige Objekte geeignet ist und lediglich eine verzerrte Abbildung des durchsichtigen Objekts erzeugt.

Eine ähnliche,Vorrichtung ist aus der DE-A 31 06 398 A1 bekannt. Es handelt sich hierbei um eine einfachere Konstruktion ohne eigene Beleuchtungseinrichtung. Mit dieser bekannten Vorrichtung lassen sich Einzelabbildungen zweier unterschiedlicher Ansichten von beliebigen, auch undurchsichtigen Objekten erzeugen. Nachteilig ist, daß die zu überprüfenden Objekte einzeln im Abbildungsbereich positioniert werden müssen.

Sowohl die aus der DE-AS-26 17 457 bzw. der US-A-4,025,201 als auch die aus der DE-A 31 06 398 A1 bekannte Vorrichtung ist aufgrund der Anordnung ihrer optischen Elemente bzw. Spiegel nicht für vergleichsweise kleine Objekte, wie z. B. SMD-Bauteile geeignet.

Bei diesem bevorzugten Anwendungsbereich der vorliegenden Erfindung ist das abzubildende bzw. zu prüfende dreidimensionale Objekt ein elektronisches Bauelement mit Anschlüssen. Die automatisierte Überprüfung umfaßt die Positionsbestimmung der Anschlüssse in einem dreidimensionalen Koordinatensystem und/oder Teilungsprüfung und/oder Koplanaritätsprüfung der Anschlüsse des elektronischen Bauelements.

Bei der automatischen Bestückung von Leiterplatten mit elektronischen Bauelementen werden die einzelnen Bauelemente mittels einer Zuführeinrichtung aus einem Magazin oder dergleichen entnommen und anschließend auf der Leiterplatte positioniert und verlötet. Bekanntermaßen sind die elektronischen Bauelemente in IC-Gehäusen untergebracht. Die Verbindung zu den Kontakten (Löt-Pads) der Leiterplatte wird über Anschluß-Beinchen hergestellt. Zum Zeitpunkt der Bestückung sind die Löt-Pads mit einem Lot-Depot (meist Lot-Paste) versehen. Nach der Bestückung wird das Lot-Depot erhitzt und umhüllt dabei das Beinchen. Durch diese Verbindung wird das IC-Gehäuse mechanisch auf der Leiterplatte gehalten und die elektrische Verbindung hergestellt. Bei IC-Gehäusen für die Oberflächen-Bestückung (Surface Mounted Devices, SMD's) besteht die Notwendigkeit, daß alle Beinchen eines IC-Gehäuses auf den Löt-Pads liegen (X-Y-Lage, pad-fit) und etwa in einer Ebene (d.h. koplanar) sind, damit sie beim Löten in das Lot-Depot ragen und dabei den Kontakt zum Löt-Pad erhalten. Bei hochpoligen IC-Gehäusen (etwa ≥ 20 Beinchen), besonders jedoch bei kleiner Teilung (Mittenabstand der Beinchen ≤ 0,5 mm, fine-pitch) werden Inspektions-Systeme für die Beinchen zwingend notwendig. An die Inspektion der Beinchen-Geometrie werden sehr hohe Anforderungen gestellt. Die Messungen erfolgen im Mikrometer-Bereich; die Genauigkeit und die Wiederholgenauigkeit der Messung bestimmen die Meßqualität und damit auch die Anzahl der noch brauchbaren Bauelemente für die Bestückung auf der Leiterplatte.

Es werden Inspektions-Systeme benötigt, mit denen die dreidimensionale Ausrichtung der Beinchen von IC-Gehäusen überprüft werden kann. Solche Systeme sind jedoch technisch aufwendig (es werden beispielsweise fünf Kameras benötigt) und damit teuer. Andererseits sind solche Systeme signifikanten Beschränkungen unterworfen. So ist bei manchen bekannten Anordnungen die Handhabung des IC-Gehäuses kompliziert, und es können nur bestimmte Gehäuse-Typen geprüft werden.

Es ist daher von Vorteil, die an sich bekannte dreidimensionale Inspektion in zwei Schritte zu unterteilen: horizontale Inspektion und Koplanaritäts-Inspektion.

Bei der horizontalen Inspektion erfolgt eine zweidimensionale Inspektion der Beinchen auf Anwesenheit, X-Y-Ausrichtung (pitch, deviation, group span, location), Bestimmung von Korrektur-Parametern für die Bauteil-Lage und Pad-Fit (X-Y-Lagekorrektur und Drehwinkel Theta), und Pin-1-Erkennung. Bei der Koplanaritäts-Inspektion erfolgt eine Inspektion der Beinchen in ihrer Z-Höhe (Koplanarität) durch Berechnung der Aufsetz-Fläche über die drei tiefsten Beinchen, die den Schwerpunkt des IC-Gehäuses umschließen, Berechnung der Beinchen-Koplanarität in Bezug zur Aufsetz-Fläche, und Bestimmung des Abstandes der Aufsetz-Fläche zur Gehäuse-Unterkante (package stand-off).

Hinsichtlich der bisher bekannten Anordnungen und Verfahren zur Lage- und Teilungsprüfung der Anschlußbeinchen von Bauelementen wird auf die folgenden Veröffentlichungen hingewiesen:
- Ueli Meili, Quasys, in Productronic, Nr. 10, 1993, "Qualitätsprüfung an SMD-Pins - Quo Vadis?";
- John Farrell, Cahners Economics, Newton, Mass., USA, in Semiconductor International, Nr. 53, October 1993, "Economic Indicator";
- Günther Schiebel, Siemens AG AUT 5, in Productronic, Nr. 11, 1993, "Ins rechte Licht gerückt";
- Blaupunkt, in EPP Elektronik Produktion & Prüftechnik, Nr. 11, November 1993, "Ball-Grid-Arrays ersparen Fine-Pitch";
- Wolfgang Schuh, in Productronic, Nr. 3, 1990, "Automatische optische Inspektion von SMD-Baugruppen - Die Spreu vom Weizen trennen";

Der letztgenannte Artikel von Wolfgang Schuh stellte eine Übersicht der auf dem Markt befindlichen Systeme zur automatischen optischen Inspektion von SMD-Baugruppen dar.

Eine Vorrichtung zum Abbilden eines dreidimensionalen Objekts nach dem Oberbegriff des Anspruchs 1 ist aus der US-A-4,959,898 bekannt.

Diese bekannte Vorrichtung umfaßt eine Bilddarstellungseinrichtung in Form einer Kamera, eine optische Abbildungsanordnung bestehend aus einer Mehrzahl von Spiegeln, die gleichzeitig fünf Einzelabbildungen von unterschiedlichen Ansichten der SMD-Komponente auf die gemeinsame Bildfläche einer CCD-Kamera projiezieren. Mittels einer ringförmigen Beleuchtungseinrichtung wird der zwischen Spiegeln liegende Abbildungsbereich bzw. ein im Abbildungsbereich befindliches SMD-Bauteil ausgeleuchtet. Durch Referenzmessungen mittels eines dreidimensionalen Eichteils lassen sich die Positionen der Anschlußbeinchen in einem XYZ-Koordinatensystem bestimmen. Nachteilig bei dieser bekannten Vorrichtung ist es, daß das SMD-Bauteil in den Abbildungsbereich "eintauchen" muß, wodurch eine komplizierte und aufwendige Handhabungsautomatik erforderlich wird. Beim Eintauchen in den Abbildungsbereich besteht die Gefahr der Beschädigung der Anschluß-Beinchen des SMD-Bauteils. Ein weiterer Nachteil besteht darin, daß die hochgenaue Fertigung des Eichteils extrem kostspielig ist.

Aus der DE-A-42 09 524 ist eine Vorrichtung und ein Verfahren zur Lageerkennung, Teilungs- und Koplanaritätsprüfung von SMD-Bauteilen bekannt, bei dem der Schattenwurf des SMD-Bauteils auf eine ortsauflösende CCD-Kamera genutzt wird.

Aus der WO-A-91/15104 ist ein Verfahren und eine Vorrichtung zur Inspektion von SMD-Bauteilen bekannt, bei dem ebenfalls der Schattenwurf aufgrund von Licht aus unterschiedlichen Richtungen zur Bestimmung der XYZ-Koordinaten ausgenutzt wird.

Aus der DE 41 39 189 A1 ist ein Verfahren und eine Vorrichtung zur Inspektion von SMD-Bauteilen bekannt, das drei Kameras verwendet. Das SMD-Bauteil wird mittels eines Laserstrahls vermessen.

Aus der DE 40 32 327 C2 und der EP-A-0 385 474 sind ebenfalls Verfahren und Vorrichtungen zur Überprüfung von Halbleiterbauteilen bekannt, bei denen spezielle Lichtquellen zur kontrastreichen Ausleuchtung der zu prüfenden Bauteile verwendet werden.

Jedes der vorgenannten bekannten Syteme weist einen oder mehrere der folgenden Nachteile auf:
1. Gesamt-Bearbeitungszeit (Transport, Aufnahme und Bildverarbeitungalgorithmus) zu langsam, meist mehrere Sekunden pro IC-Gehäuse;
2. IC-Gehäuse dürfen während der Abbildung bzw. Messung nicht bewegt werden;
3. Mehrere Einzelabbildungen nacheinander sind notwendig, zwischen Einzelabbildungen müssen die Bauteile bewegt werden (Transport, Z-Bewegung oder Rotation). Weil der Meßzyklus eine längerd Zeitspanne dauert, gehen Vibrationen und Schwingungen der Anlage sowie der gesamten Umgebung signifikant als Meßfehler in das Meßergebnis ein.
4. Einschränkungen des IC-Gehäusespektrums durch bestimmte geometrische Anordnungen (beispielsweise entweder J-Lead oder Gull-Wing);
5. Große Abmessungen des Koplanaritätssensors, schlecht integrierbar;
6. Verschmutzung des Sensors;
7. Verwendung von 1024²-Pixel-Kameras oft nicht möglich, entsprechend Frame-Grabber (noch) nicht verfügbar;
8. Kombination mit X-Y-Beinchen-Inspektion nicht möglich, jedenfalls nicht aus einer Hand, d.h. zusätzliche Integrations-Aufwände;
9. Die Fertigung von Kalibrierteilen ist extrem kostspielig.

Demgemäß liegt der Erfindung die Aufgabe zugrunde, eine vorrichtungstechnisch einfache und daher kostengünstige, universell einsetzbare, einfach handhabbare Vorrichtung zum Abbilden und Überprüfen eines dreidimensionalen Objektes zur Verfügung zu stellen. Weiter ist es Aufgabe der vorliegenden Erfindung, ein Verfahren zum Kalibrieren der Vorrichtung sowie ein Verfahren zum Überprüfen der Beschaffenheit von dreidimensionalen Objekten mit der vorgenannten Vorrichtung zur Verfügung zu stellen.

Diese Aufgaben werden durch die Vorrichtung gemäß Anspruch 1 sowie Verfahren gemäß den Ansprüchen 20 und 21 gelöst.

Erfindungsgemäß umfaßt die Vorrichtung zum Abbilden eines sich in einem Abbildungsbereich befindenden dreidimensionalen Objektes eine Bilddarstellungseinrichtung, eine optische Abbildungsanordnung mit mehreren optischen Elementen und eine Beleuchtungseinrichtung zum kurzzeitigen Beleuchten des dreidimensionalen Objekts, wenn es sich im Abbildungsbereich befindet. Es werden gleichzeitig Einzelbilder von wenigstens zwei unterschiedlichen Ansichten des dreidimensionalen Objekts auf eine gemeinsame Bildfläche einer Bilddarstellungseinrichtung projiziert. Die optischen Elemente der Abbildungsanordnung können Spiegel, Oberflächen-spiegel oder Prismenspiegel, Lichtwellenleiter, Linsen usw. umfassen. Durch die Beleuchtungseinrichtung in Form eines Blitzlichts wird das zu prüfende Objekt in dem Moment angeleuchtet, wenn es sich im Abbildungsbereich befindet. Eine solche kurzzeitige Beleuchtung des Objektes hat zudem den Vorteil, daß die thermische Belastung aufgrund der Beleuchtung gering gehalten wird.

Dadurch, daß sich der Abbildungsbereich außerhalb von jeder Sichtlinie zwischen den einzelnen optischen Elementen der optischen Abbildungsanordnung und außerhalb von jeder Sichtlinie zwischen der Beleuchtungseinrichtung und den einzelnen optischen Elementen der optischen Abbildungsanordnung befindet, ist eine Prüfung der Objekte "on-the-fly" möglich. D. h. die zu prüfenden Objekte durchfahren den Abbildungsbereich ohne Richtungsänderung, werden im richtigen Moment angeblitzt und genau in diesem Moment erfolgen gleichzeitig die verschiedenen Einzelabbildungen. Des weiteren ergibt sich dadurch ein kompakter Aufbau und eine verbesserte Integrierbarkeit in Fertingungsanlagen für IC-Gehäuse (Trim & Form, Tape & Reel, Lead Conditioner etc.), sowie in Bestückungsautomaten. Die Automatisierbarkeit der Objektprüfung wird durch die Prüfung "on-the-fly" wesentlich vereinfacht, da keine komplizierte Handhabung - keine Richtungsänderung kein Anhalten etc. - der Objekte zur Prüfung notwendig ist.

Durch die gleichzeitige Projektion unterschiedlicher Ansichten eines dreidimensionalen Objekts auf die Bildfläche der Bilddarstellungseinrichtung und deren Anzeige, beispielsweise auf einem Monitor, ist sozusagen eine "Rundum-Inspektion" eines dreidimensionalen Objekts mit einem Blick auf den Monitor möglich. Damit kann beispielsweise mit einem Blick überprüft werden, ob eine bestimmte Aufschrift auf der Vorder- und auf der Rückseite eines dreidimensionalen Objekts korrekt aufgebracht worden ist oder nicht. Dabei ist es vorteilhafterweise nicht notwendig, daß das Objekt gedreht oder in sonstiger Weise manipuliert wird. Es genügt, wenn das zu prüfende Objekt den Abbildungsbereich durchfährt.

Die Geschwindigkeit, mit der die zu prüfenden Objekte den Abbildungsbereich durchfahren, bestimmt zusammen mit der Empfindlickeit bzw. Reaktionszeit der Bilddarstellungseinrichtung die Dauer des Abildungsintervalls und damit die Dauer des Blitzlichtimpulses. Bei Beleuchtungsintervallen bzw. Blitzlichtimpulszeitdauern im µs-Bereich ergeben sich bei Objektgeschwindigkeiten von ca. 1 m/s im Abbildungsbereich sicher scharfe Bilder (Anspruch 7). Zur Erzeugung eines ausreichend scharfen Bildes ist es auch denkbar, die aufgrund einer konstant eingestellten Geschwindigkeit des Objektes zu erwartende Bild-Unschärfe durch geeignete Bildverarbeitungsmaßnahmen rechnerisch zu kompensieren.

Gemäß einer bevorzugten Ausgestaltung der Erfindung liegt der Abbildungsbereich auch außerhalb von jeder Sichtlinie zwischen der Bilddarstellungseinrichtung und den einzelnen optischen Elementen der optischen Abbildungsanordnung. Dadurch ist der Abbildungsbereich noch mehr im Raum exponiert und damit aus vielen Richtungen zugänglich und ohne Richtungsänderung durchfahrbar. Dieser Effekt wird noch verstärkt, wenn der Abbildungsbereich zusätzlich auch außerhalb jeder Sichtlinie zwischen der Beleuchtungseinrichtung und der Bilddarstellungseinrichtung bzw. der optischen Abbildungsanordnung liegt. Die Beleuchtungseinrichtung und die Bilddarstellungseinrichtung können, wie die optische Abbildungsanordnung aus mehreren Komponenten bestehen. Die Sichtlinien werden dann zwischen den jeweiligen Komponenten gezogen. (Anspruch 2)

Gemäß einer bevorzugten Ausgestaltung der Erfindung bestehen die optischen Elemente der Abbildungsanordnung aus einer Vielzahl von Spiegeln. Die Spiegel sind hierbei solchermaßen angeordnet, daß die Ansichten der zumindest zwei Seiten des Objektes nebeneinander auf der Bildfläche erscheinen. Zur Vermeidung von Doppel-Brechung sind Oberflächen-Spiegel bevorzugt. Im übrigen soll der Begriff Spiegel eine jede optische Einrichtung umfassen, die Licht reflektiert bzw. in eine andere Richtung ablenkt, beispielsweise auch Umlenkprismen. (Anspruch 3)

Bei einer besonders bevorzugten Ausgestaltung der erfindungsgemäßen Vorrichtung weist der Strahlengang jeder Einzelabbildung, ausgehend von der zentralen Abbildungsposition innerhalb des Abbildungsbereichs bis zur gemeinsamen Bildfläche, die gleiche Länge auf. Insbesondere bei der Verwendung einer CCD-Kamera als Bilddarstellungseinrichtung ergibt sich im Rahmen des Tiefenschärfe-Bereichs eine gleichmäßig scharfe Abbildung aller Einzelabbildungen auf der gemeinsamen Bildfläche. (Anspruch 4)

Bei einer besonders bevorzugten Ausgestaltung der Erfindung ist die optische Abbildungsanordnung und die Beleuchtungseinrichtung in einem abgeschlossenen Gehäuse untergebracht, welches ein Fenster zur Detektion des außerhalb des Gehäuses angeordneten Objekts aufweist. Insbesondere ist ein staubdicht abgeschlossenes Gehäuse bevorzugt. Zur Vermeidung von Druck-Problemen kann das Gehäuse mit einer staubdichten Ausgleichs-Bohrung (Filter) versehen sein. Zur Vermeidung der Bildung von Feuchtigkeit innerhalb des Gehäuses können geeignete Maßnahmen (hygroskopisches Säckchen, Silica-Gel) getroffen sein. Bei einer besonders einfachen Ausgestaltung kann das Gehäuse aus einem Kunststoffmaterial mit nach innen hineinragenden schrägen Flächen, auf denen die Spiegel angebracht sind, hergestellt sein. Die Unterbringung von Beleuchtungseinrichtung und optischer Abbildungsanordnung in einem abgeschlossenen Gehäuse wird auch durch den Umstand erleichtert, daß der Abbildungsbereich gemäß Anspruch 1 und 2 außerhalb der Sichtlinien angeordnet ist. (Anspruch 5)

Bei einer bevorzugten Ausgestaltung der erfindungsgemäßen Vorrichtung ist das Fenster als trogförmige Vertiefung in einer Oberfläche des Gehäuses ausgebildet. Das Fenster weist zumindest eine transparente Seitenwand auf, die im Strahlengang zwischen dem Objekt und dem am nächsten angeordneten, zugehörigen Spiegel angebracht ist. Vorzugsweise sind die Seitenwände des Fensters zur Bodenfläche im stumpfen Winkel angeordnet, damit die auf das Objekt gerichteten Lichtstrahlen die Seitenwände möglichst senkrecht durchtreten. Die Bodenfläche kann entweder als lichtundurchlässige oder auch lichtdurchlässige oder lichtdurchscheinende Fläche ausgebildet sein. Die Anordnung des Fensters ist bevorzugtermaßen derart gewählt, daß die vier Seitenwände parallel bzw. senkrecht zur Transportrichtung des Objektes verlaufen. Der Abbildungsbereich befindet sich vorzugsweise mittig über dem Fenster, jedoch außerhalb der Vertiefung und des Gehäuses. (Anspruch 6)

Die Beleuchtungseinrichtung sorgt für eine möglichst optimale Beleuchtung des Objektes im Auflicht. Dies kann beispielsweise eine punktförmige Lichtquelle sein, aber auch eine flächenhafte Lichtquelle, beispielsweise in der Form einer Vielzahl von einzeln oder gruppenweise ansteuerbarer Leuchtdioden, die beispielsweise in einer der Gestalt des zu beleuchtenden Objektes entsprechenden Form angeordnet sind. Durch eine ringförmige Ausgestaltung (Anspruch 8) ergibt sich eine gleichmäßige Ausleuchtung des zu prüfenden Objekts.

Die Wellenlänge des von der Lichtquelle abgegebenen Lichtes ist je nach Anwendungsfall geeignet gewählt. Bei der Abbildung metallischer Gegenstände hat sich insbesondere eine Beleuchtung mit rotem Licht oder mit Licht im nahen Infrarot-Bereich bewährt, sofern Einzelheiten metallischer Korngrenzen und sonstiger mikroskopischer Einzelheiten nicht erfaßt werden sollen. (Anspruch 11)

Durch eine geeignete Filtereinrichtung, beispielsweise vor der Bilddarstellungseinrichtung, kann Licht, das nicht von der Beleuchtungseinrichtung stammt ausgefiltert werden (Anspruch 12). Dadurch wird verhindert, daß Fremdlicht, wie Sonnenlicht oder künstliche Beleuchtung in Räumen, die Qualität der Abbildungen beeinflußt.

In besonderer Ausgestaltung der Erfindung ist unter der Bildfläche hierbei die lichtempfindliche Fläche eines ortsauflösenden opto-elektronischen Wandlers, insbesondere einer CCD-Matrix-Kamera zu verstehen. Auf diese Weise wird die Automatisierung der Prüfung von Objekten mittels nachgeschalteter Bildverarbeitungseinrichtungen vereinfacht. (Anspruch 13)

Durch die Verwendung einer elektronisch auslös- bzw. triggerbaren Kamera ist auf einfache Weise eine Kopplung und Synchronisation der Blitzlichtbeleuchtung mit der Kamera möglich. (Anspruch 14)

Bei den zu prüfenden Objekten handelt es sich vorzugsweise um Bauelemente für die Oberflächenmontage (Surface Mounted Device), d. h. um IC-Gehäuse mit den Beinchentypen J-Lead und Gull-Wing, oder um Bauelemente mit Ballpoint-Anschlüssen oder dergleichen. (Anspruch 15)

Gemäß einer besonders bevorzugten Ausgestaltung der Erfindung ist eine Bildverarbeitungseinrichtung zum Berechnen der Koordinaten von Bildpunkten des dreidimensionalen Objekts aus den wenigstens zwei Einzelbildern vorgesehen (Anspruch 16). Auf diese Weise können beliebige Lage-Koordinaten in zwei oder drei Dimensionen des gesamten Objekts oder von Bestandteilen oder Teilbereichen des Objekts ermittelt werden.

Gemäß einer besonders bevorzugten Ausführungsform umfaßt die Erfindung ein Kalibrierteil in Form einer planparallelen Platte aus einem formstabilen Material, z. B. Glas. Auf der Glasplatte ist ein Markierunsmuster aufgeätzt, dessen Lage und Abmessungen hochgenau ausgeführt sind. Das Kalibrierteil läßt sich mittels einer Befestigungsvorrichtung hochgenau und reproduzierbar im Abbildungsbereich anordnen. Beispielsweise mittels Mikrometerschrauben läßt sich das Kalibrierteil in Z-Richtung definiert verschieben (die Ebene der Glasplatte mit dem Markierunsmuster bildet hierbei die XY-Ebene).

Durch das Anordnen des Kalibrierteils mit dem flächigen Markierungsmuster in unterschiedlichen Höhen in Z-Richtung im Abbildungsbereich wird quasi mit einem zweidimensionalen Kalibrierteil (das hochgenaue Markierungsmuster) ein dreidimensionales Kalibrierteil simuliert. Aus der Ausmessung des hinsichtlich Lage und Abmessung bekannten Markierungsmusters und aus dem bekannten Höhe des Markierungsmusters über dem Fenster in Z-Richtung läßt sich eine Transformationsmatrix ermitteln. Da sich eine planparallel Platte mit einem zweidimensionalen Markierungsmuster wesentlich einfacher mit der notwendigen Genauigkeit fertigen läßt als ein dreidimensionales Kalibrierteil, wie es aus der US-A-4,959,898 bekannt ist, läßt sich das erfindungsgemäße Kalibrierteil erheblich kostengünstiger herstellen.

Durch die Kopplung bzw. Synchronistion der Bewegung der Objekte, der Blitzlichtbeleuchtung und der Kameraauslösung läßt sich die Überprüfung der Objekte vollständig automatisieren.

Weitere Einzelheiten, Aspekte und Vorteile der vorliegenden Erfindung ergeben sich aus der nachfolgenden Beschreibung unter Bezugnahme auf die Zeichnung.

Es zeigt:
- Fig. 1: eine schematische Ansicht eines Ausführungsbeispieles der erfindungsgemäßen Vorrichtung mit einem quaderförmigen Fenster;
- Fig. 2: eine schematische Draufsicht des Ausführungsbeispieles gemäß Fig. 1;
- Fig. 3: eine schematische Darstellung zur Erläuterung der prinzipiellen Anordnung der Spiegel in der Abbildungsanordnung mit zwei Strahlengängen;
- Fig. 4: eine schematische Ansicht eines typischen Spiegels der Abbildungsanordnung;
- Fig. 5: eine Fig. 3 entsprechende Darstellung mit vier Strahlengängen;
- Fig. 6: eine schematische Darstellung der auf der gemeinsamen Bildfläche der Bildverarbeitungseinrichtung abgebildeten Seitenansichten der vier Seiten eines SMD-Bauelementes;
- Fig. 7: eine schematische Darstellung einer auf einer weiteren Bildfläche abgebildeten Unteransicht des SMD-Bauelementes;
- Fig. 8: eine schematische Darstellung der Beleuchtungseinrichtung mit Lichtquellen in unterschiedlichen Ebenen;
- Fig. 9: ein Diagramm mit spektralen Eigenschaften verschiedener Komponenten der Erfindung;
- Fig. 10: das Kalibrierteil mit flächigem Markierungsmuster in Aufsicht;
- Fig. 11: eine schematische Darstellung des im Abbildungsbereich montierten Kalibrierteils;
- Fig. 12: eine schematische Darstellung in Z-Richtung verschiedener Abbildungspositionen des Kalibrierteils;
- Fig. 13: eine schematische Darstellung eines automatischen Prüfsystems für SMD-Bauteile;
- Fig. 14: ein Zeitdiagramm zur Funktion des Prüfsystems nach Fig. 13;
- Fig. 15: eine schematische Draufsicht des SMD-Bauelementes vom Typ Gull-Wing;
- Fig. 16: eine schematische Seitenansicht des SMD-Bauelementes;
- Fig. 17: eine schematische Unteransicht eines SMD-Bauelementes vom Typ J-Lead; und
- Fig. 18: eine schematische Seitenansicht des Bauelementes.

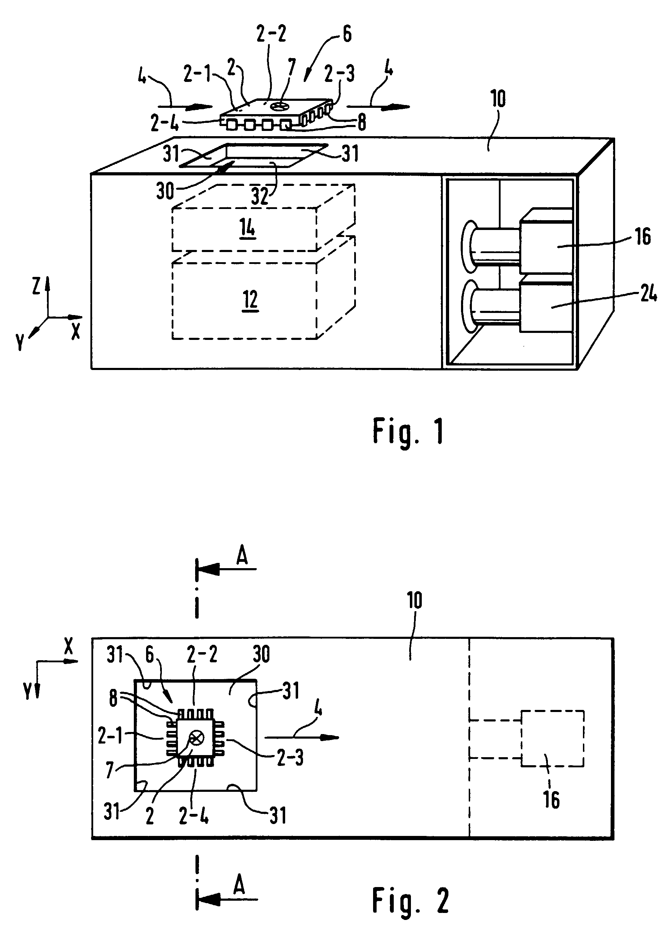

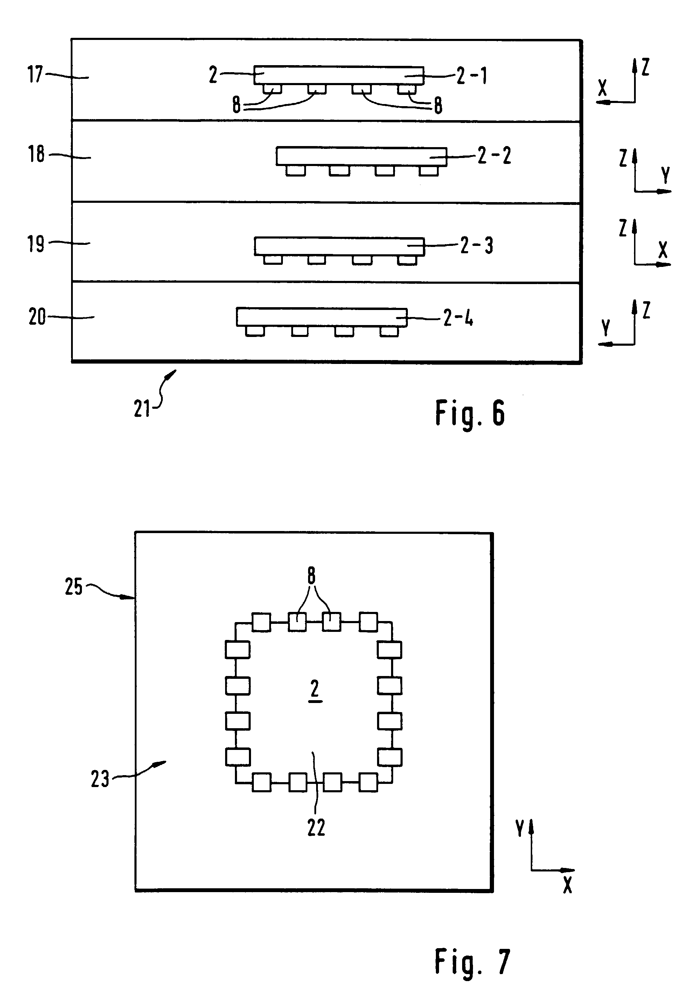

Die Fig. 1 und Fig. 2 zeigen in stark vereinfachter schematischer Darstellung eine erste Ausführungsform der Erfindung, der ein zu prüfendes Bauelement 2 in einer Transportrichtung gemäß Pfeil 4 in einen Abbildungsbereich 6 zugeführt wird. Zentral im Abbildungsbereich 6 liegt eine Abbildungsposition 7. Bei dem dargestellten Bauelement 2 handelt es sich um ein oberflächenmontierbares IC-Gehäuse vom Beinchen-Typ "J-Lead", das auf jeder der vier Bauelementseiten 2-1, 2-2, 2-3, 2-4 vier Anschlüsse bzw. Beinchen 8 besitzt. Innerhalb eines vorzugsweise staubdicht abgeschlossenen Gehäuses 10 ist eine optische Abbildungsanordnung 12 und eine Beleuchtungseinrichtung 14 angeordnet. Die Abbildungsanordnung 12 ist optisch auf die zentrale Abbildungsposition 7 hin ausgelegt. Ein ortsauflösender opto-elektronischer Wandler in Form einer ersten CCD-Matrix-Kamera 16 ist derart angeordnet, daß nach Beleuchtung des Bauelementes 2 mit Licht geeigneter Wellenlänge aus der Beleuchtungseinrichtung 14 gleichzeitig Einzelabbildungen 17, 18, 19, 20 von jeder Bauelementseite 2-1, 2-2, 2-3, 2-4 des Bauelementes 2 auf seiner lichtempfindlichen Bildfläche, d. h. auf einer gemeinsamen Bildfläche 21 erzeugt werden. Die Anordnung der vier Einzelabbildungen 17 bis 20 auf der gemeinsamen Bildfläche 21 ist schematisch in Fig. 6 dargestellt. Gleichzeitig wird von einer Unterseite 22 des Bauelementes 2 eine weitere Einzelabbildung 23 gemäß Fig. 7 auf die Bildfläche 25 einer separat angeordneten zweiten CCD-Matrix-Kamera 24 erzeugt.

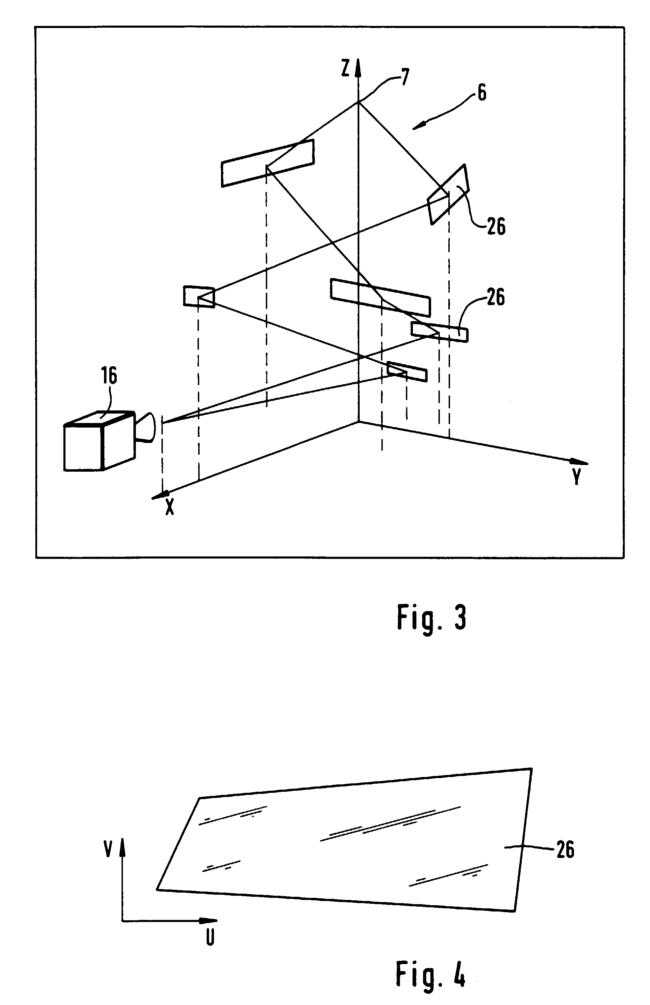

Die in den Fig. 3 bis 5 näher dargestellte optische Abbildungsanordnung 12 besteht aus einer Vielzahl von optischen Elementen in Form von Spiegeln 26. Die Spiegel 26 sind dergestalt justiert angeordnet, daß die vier Seiten 2-1, 2-2, 2-3, 2-4 des Bauelementes 2 gleichzeitig auf die Bildfläche der ersten CCD-Kamera 16 abgebildet werden, und zwar derart, daß die einzelnen Seitenansichten 17 bis 20 nebeneinander auf der gemeinsamen Bildfläche 21 der CCD-Kamera 16 erscheinen. Die Anzahl und Anordnung der einzelnen Spiegel 26 ist dabei so gewählt, daß jede Einzelabbildung 17, 18, 19 oder 20 mit der richtigen Lage und mit gleichem Fokus auf der Bildfläche 21 der CCD-Kamera 16 erscheint.

Bei der beispielhaft dargestellten Abbildungseinrichtung sind elf Spiegel 26 vorgesehen, also drei Spiegel für jede abzubildende Seite mit Ausnahme der unmittelbar der Bildfläche der CCD-Kamera 16 gegenüberliegenden Seite des Bauelementes 2, für deren Abbildung lediglich zwei Spiegel benötigt werden. Zur Veranschaulichung sind in Fig. 3 lediglich zwei Strahlengänge mit zugeordneten Spiegeln 26 dargestellt. Eine beispielhafte Form der Spiegel 26 ist aus Fig. 4 zu ersehen. Die jeweilige Form der Spiegel 26 ergibt sich aufgrund eines Schnittes durch eine rechtwinkelige Pyramide. Diese Schnitte ergeben die Spiegelflächen, die für die Abbildung tatsächlich genutzt werden. Aus fertigungstechnischen Gründen können die Spiegel 26 auch rechtwinkelig sein, wobei dann die genannten Pyramidenschnittflächen Teilflächen der rechteckigen Spiegelflächen sind.

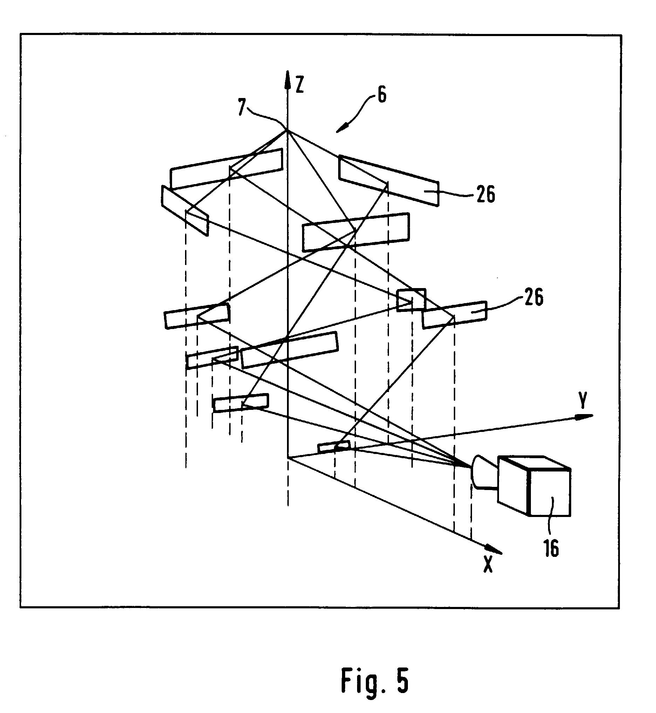

In Fig. 5 sind statt lediglich zwei vier Strahlengänge mit beteiligten Spiegeln 26 dargestellt, um die Einzelabbildungen von den vier Bauelementseiten 2-i zu veranschaulichen. In den Figuren 3 und 5 ist jeder Strahlengang vom Objekt über die Spiegel 26 zur gemeinsamen Bildfläche 21 der ersten CCD-Kamera 16 über durchgezogene Linien angedeutet. Durch die gestrichelten Linien ist eine Verbindungslinie vom Mittelpunkt jedes Spiegels zum zugehörenden Fußpunkt in der XY-Ebene dargestellt, um sich die räumliche Lage jedes Spiegels 26 im XYZ-Koordinatensystem besser vorstellen zu können. Aus den Figuren 3 und 5 ist die abgesetzte bzw. exponierte Anordnung des Abbildungsbereichs 6 bzw. der Abbildungsposition 7 sehr gut zu erkennen, die es ermöglicht, daß die Bauelemente 2 ohne Richtungsänderung durch den Abbildungsbereich 6 hindurch bewegt werden können.

Zur Detektion des Bauelementes 2 mittels der innerhalb des Gehäuses 10 untergebrachten Abbildungsanordnung 12 ist auf der Oberseite des Gehäuses 10 ein trogförmiges Fenster 30 vorgesehen, welches die Strahlengänge der Abbildungsanordnung 12 und der Beleuchtungseinrichtung 14 auf das Bauelement 2 freigibt, wenn es sich im Abbildungsbereich 6 befindet. Das Fenster 30 besitzt für das von der Beleuchtungseinrichtung 14 ausgehende Licht transparente Seitenwände 31 und eine Bodenplatte 32. Die Seitenwände 31 sind im Strahlengang zwischen Objekt und demjenigen Spiegel 26 angeordnet, der der abzubildenden Seite am nächsten liegt. Idealerweise verläuft die Flächennormale jeder Seitenwand 31 möglichst parallel zu dem dazugehörenden Strahlengang der Spiegelanordnung, um Ungenauigkeiten und Unschärfen in der Abbildung aufgrund von Doppelbrechungen des Lichtstrahles an einer Seitenwand 31 oder Intensitätsverluste des durch die Seitenwand 31 hindurchgehenden Lichtes zu vermeiden. Falls eine ausreichende Meßgenauigkeit gewährleistet ist, kann jede Seitenwand 31 des Fensters 30 selbstverständlich auch schräg zum Strahlengang angeordnet sein.

Bei dem Ausführungsbeispiel gemäß Fig. 1 und 2 ist das Fenster 30 in der Form einer trogförmigen Vertiefung in der gemäß Fig. 1 oberen Oberfläche des Gehäuses 10 ausgebildet. Das in Fig. 1 dargestellte Fenster 30 weist senkrecht stehende Seitenwände 31 auf, die parallel bzw. senkrecht zur Transportrichtung 4 des Bauelementes 2 verlaufen. Jede Seitenwand 31 ist im Strahlengang zwischen jeweils einer der vier Seiten des Bauelementes 2 und dem nächstliegenden Spiegel 26 angeordnet. Jeder Strahlengang tritt etwa unter einem Winkel von 15° von gemäß Fig. 1 unten schräg durch jede Seitenwand 31 des Fensters 30 auf die zugehörige Seite 2-1, 2-3 des Bauelementes 2. Der Abbildungsbereich 6 befindet sich über dem Fenster 30, oberhalb des Gehäuses 10.

Bei diesem Ausführungsbeispiel betrachtet somit die erste CCD-Kamera 16 das Bauelement 2 schräg von unten, wobei jeweils die gegenüberliegende Seite 2-1 bzw. 2-3 des Bauelementes 2 fokussiert wird. Der Betrachtungs-Winkel ist etwa 15° gegen die Waagrechte, also annähernd horizontal. Die Ansichten aller vier Seiten 2-i des Bauelementes 2 werden über die Spiegelanordnung 12 zur ersten CCD-Kamera 16 geleitet, so daß alle vier Seiten 2-i gleichzeitig im Blickfeld auf der gemeinsamen Bildfläche 21 erscheinen, wie es in Fig. 6 schematisch dargestellt ist. Alle vier Strahlengänge von jeder Bauelementseite 2-i zur gemeinsamen Bildfläche 21 der CCD-Kamera 16 weisen die gleiche Länge auf, d.h. alle vier Fokus-Punkte sind von der Kamera 16 gleich weit entfernt und befinden sich in der zentralen Abbildungsposition 7.

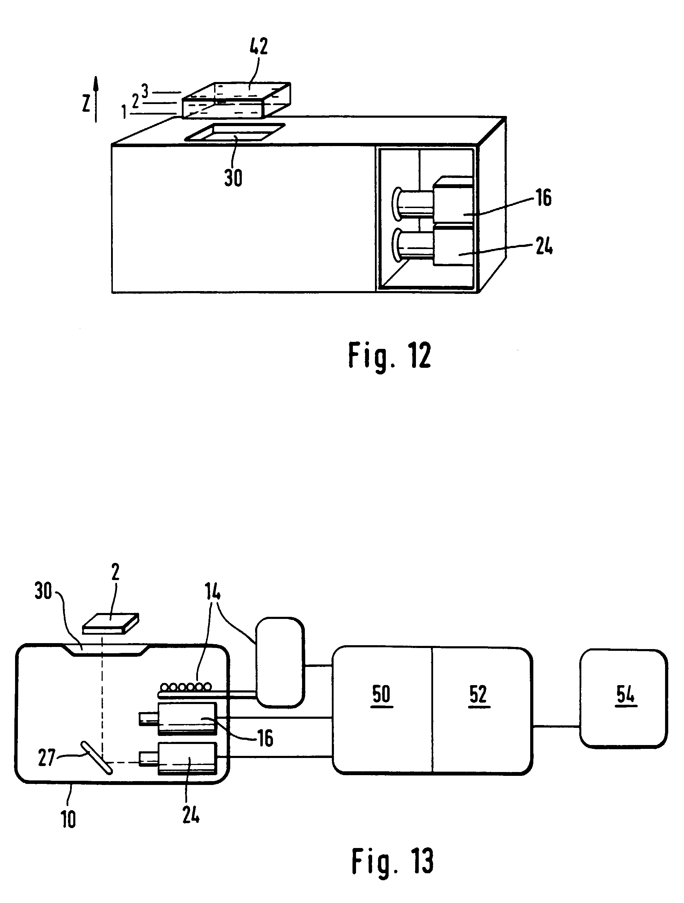

Bei der dargestellten Ausführungsform ist eine zweite CCD-Kamera 24 vorgesehen, die das Bauelement 2 von unten in Z-Richtung in der X-Y-Ebene betrachtet. Das Blickfeld dieser Abbildung ist in Fig. 7 schematisch dargestellt. Hierbei kann die weitere CCD-Kamera 24 gemäß Fig. 1 am Gehäuse 10 seitlich angeordnet sein, wobei in diesem Fall für die Abbildung der Unterseite 22 des Bauelementes 2 ein weiterer Spiegel - Bezugszeichen 27 in Fig. 13 - in geeigneter Weise angeordnet ist. Alternativ können die CCD-Kameras 16 und 24 auch an der Unterseite des Gehäuses 10 senkrecht unter dem Abbildungsbereich 6 angeordnet sein, wobei in diesem Fall für die Kamera 24 der Spiegel 27 entfallen kann.

Das Erfordernis der zweiten CCD-Kamera 24 ergibt sich hier aufgrund der geometrischen Begrenztheit des Bildausschnittes der CCD-Kamera 16. Bei einer ausreichend großen Bildfläche kann selbstverständlich auch die Unterseite 22 des Bauelementes 2 in derselben Bildfläche wie die vier Seitenansichten 2-1, 2-2, 2-3, 2-4 abgebildet sein, so daß man mit nur einer Kamera auskommt.

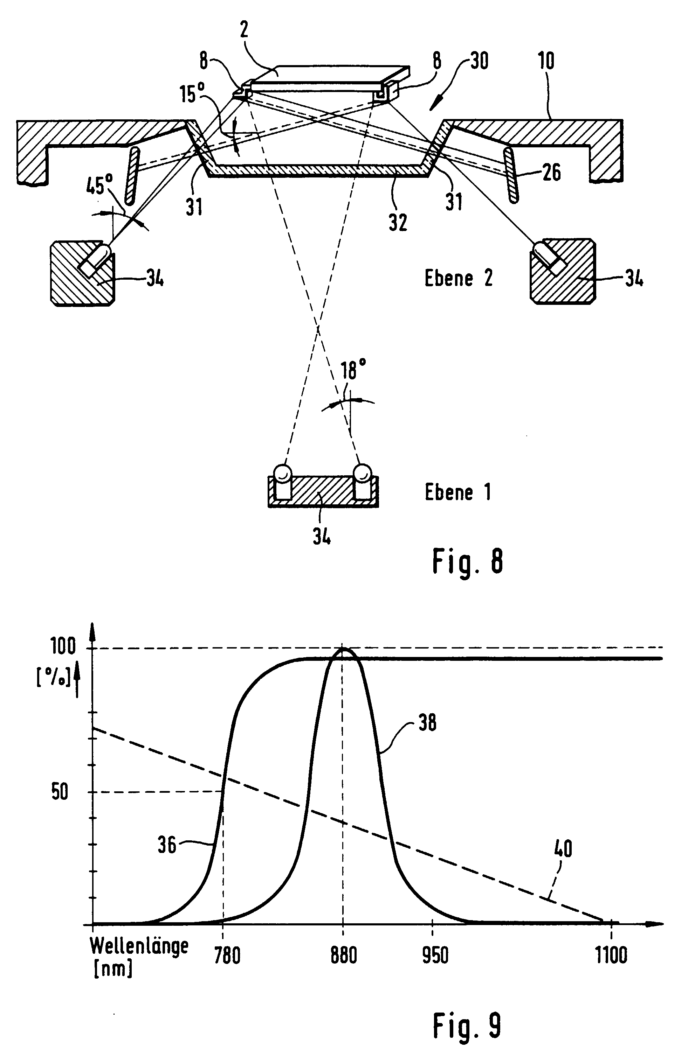

Fig. 8 zeigt schematisch einen Schnitt durch die Abbildungsvorrichtung entlang der Linie A-A in Fig. 2. Die Beleuchtungseinrichtung 14 umfaßt eine Mehrzahl von Einzellichtquellen in Form von LEDs (Leuchtdioden) 34, die in zwei Ebenen im Gehäuse 10 angeordnet sind. Aus den in Fig. 8 eingezeichneten Strahlengängen ergibt sich die Ausleuchtung des über dem Fenster 30 sich im Abbildungsbereich 6 befindlichen Bauelements 2 durch die einzelnen LEDs 34. In Fig. 8 sind die Seitenwände 31 des Fensters 30 schräg ausgeführt, so daß die verschiedenen Lichtstrahlen möglichst senkrecht die Seitenwände 31 durchsetzen. Der Blickwinkel von dem obersten Spiegel 26 zu dem Bauteil 2 im Abbildungsbereich 6 beträgt 15°, die Winkelabweichung der Blickrichtung von den LEDs 34 in der Ebene 1 beträgt 18° und von der Ebene 2 45°. Aus Fig. 8 ist zu ersehen, daß der Abbildungsbereich 6 sich außerhalb von jeder Sichtlinie zwischen den einzelnen Spiegeln 26 der optischen Abbildungsanordnung 12 und außerhalb von jeder Sichtlinie zwischen der Beleuchtungseinrichtung 14 und den einzelnen Spiegeln befindet.

Zur Ausfilterung von Störeinflüssen aufgrund von Fremdbzw. Umgebungsslicht ist ein optisches Filter (nicht dargestellt) vorgesehen, dessen Filtercharakteristik in Fig. 9 mit dem Bezugszeichen 36 versehen ist. In Fig. 9 ist die spektrale Emissionscharakteristik der LEDs 34 mit dem Bezugszeichen 38 und die spektrale Empfindlichkeit der CCD-Kameras 16 bzw. 24 mit dem Bezugszeichen 40 versehen. Aufgrund der Filtercharakteristik 36 und der spektralen Empflindlichkeit der CCD-Kameras gemäß der Kurve 40 trägt im wesentlichen nur das Licht aus den LEDs 34 zur Abbildung bei.

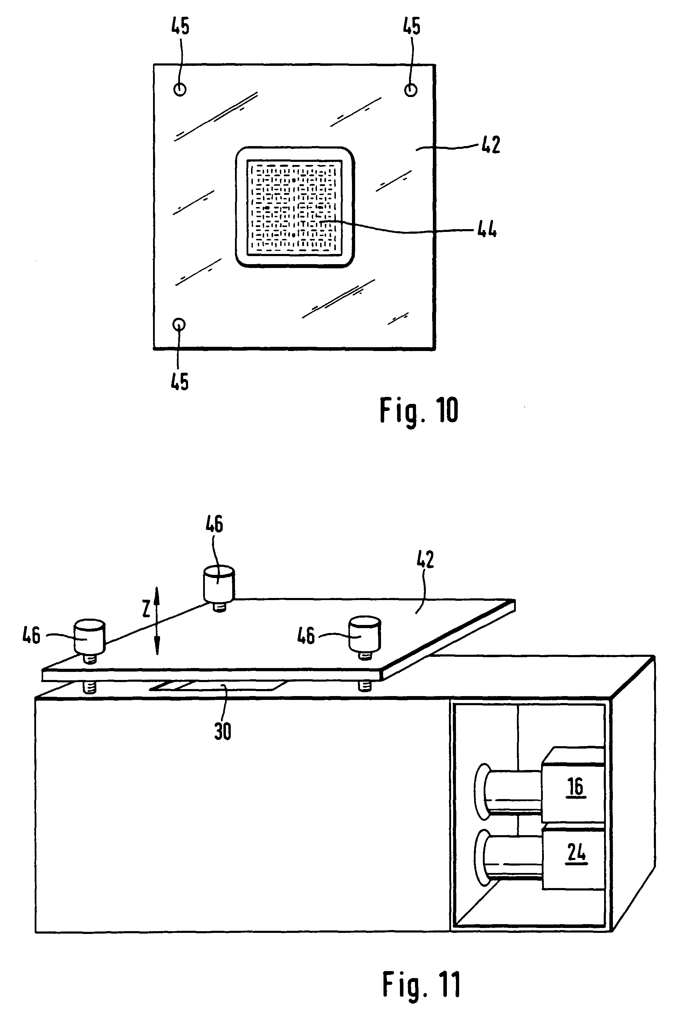

Unter Bezugnahme auf die Figuren 10 bis 12 wird die Kalibrierung der erfindungsgemäßen Abbildungsvorrichtung mittels eines speziell ausgebildeten Kalibrierteils 42 beschrieben. Das Kalibrierteil 42 besteht aus einer formstabilen Platte, z. B. aus Glas, wobei auf einer Seite ein Markierungsmuster 44 mit genau bestimmten Abmessungen und Abständen beispielsweise durch Ätzen aufgebracht ist. Im Randbereich des Kalibrierteils 42 sind Bohrungen 45 vorgesehen. Das Kalibrierteil 42 wird mit dem Markierungsmuster 44 nach unten über dem Fenster 30 im Abbildungsbereich 6 angeordnet. Mittels Mikrometerschrauben 46, die die Bohrungen 45 durchsetzen, läßt sich das Kalibrierteil 42 in Z-Richtung (das flächige Markierungsmuster 44 bildet die XY-Ebene) hochgenau und reproduzierbar verschieben. Aus der bekannten Lage und Abmessung des Markierungsmusters 44 - X- und Y-Koordinaten - und der mittels der Mikrometerschrauben 46 eingestellten Z-Koordinate läßt sich eine Transformationsmatrix bestimmen, mittels der sich aus den Meßdaten der CCD-Kameras 16 und 24 die 3D-Koordinaten beliebiger Punkte auf dreidimensionalen Objekten 2 errechnen lassen.

Anhand der schematischen Darstellung eines automatischen Prüfsystems in Fig. 13 mit Abbildungsvorrichtung, nachgeschalteter Bildverarbeitungseinrichtung 50, Steuereinrichtung 52 und Monitor 54 wird nachfolgend die Betriebsweise der erfindungsgemäßen Vorrichtung beschrieben. Das zu prüfende Bauelement 2 wird von einer (nicht näher dargestellten) Transporteinrichtung durch den Abbildungsbereich 6 über dem Fenster 30 bewegt. Erreicht das Bauelement 2 den Abbildungsbereich 6, so erfolgt die Triggerung der Beleuchtungseinrichtung 14 und der Bildverarbeitungeinrichtung 50 durch die Steuereinrichtung 52. Die Bildverarbeitungseinrichtung 50 führt gleichzeitig den beiden Kameras 16 und 24 ein Re-Start-Signal zu. Durch die optische Abbildungsanordnung 12 werden gleichzeitig von den vier unterschiedlichen Ansichten 2-i des Bauelementes 2 vier Einzelbilder 17, 18, 19, 20 nebeneinander auf die gemeinsame Bildfläche 21 der ersten CCD-Kamera 16 projeziert.

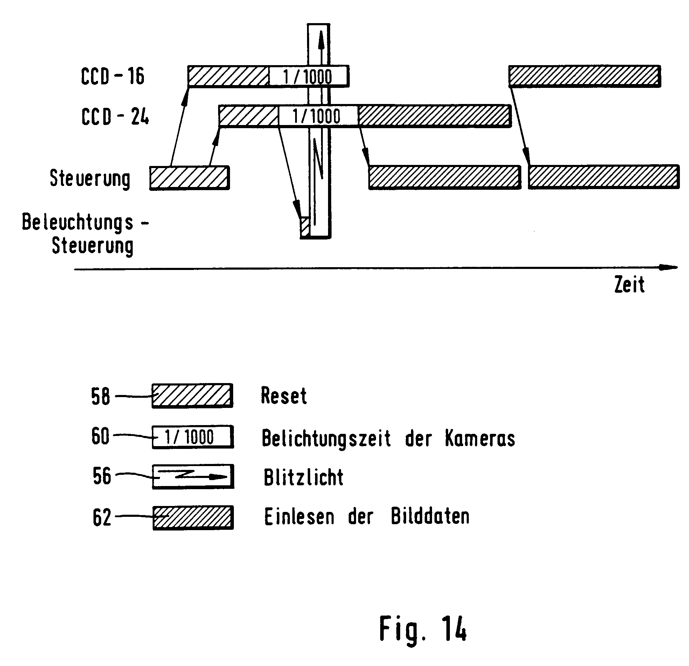

Die zeitliche Abfolge und Ansteuerung der in Fig. 13 gezeigten Vorrichtung ist in Fig. 14 dargestellt. Bei Verwendung von zwei CCD-Kameras 16 und 24 erfolgt die Belichtung innerhalb einer Zeitspanne von ca. 10 bis 40 µs (Dauer des Beleuchtungsblitzes 56). Bei einer Objektgeschwindigkeit von ca. 1 bis 0,25 m/s und einer damit verbundenen Verschmierung des Bildes von 10 µm bleibt damit die "on-the-fly"-Fähigkeit gewährleistet. Unmittelbar vor dem Blitzlicht 56, der die Belichtung für beide Kameras 16 und 24 liefert, bereitet die Steuereinrichtung 52 die beiden Kameras durch Ausgabe entsprechender Steuerbefehle 58 auf die Abbildung vor. Die Belichtungszeit 60 der beiden Kameras 16 und 24 beträgt etwa 1/1000 s. Die langsamere der beiden Kameras bestimmt den Startzeitpunkt für den Beleuchtungsblitz. Durch die annähernde Überlappung der Belichtungszeiten der beiden Kameras und des Blitzlichtes wird die Gleichzeitigkeit der verschiedenen Einzelabbildungen in beiden Kameras sichergestellt. Nach der erfolgten Abbildung werden die Bilddaten in die Bildverarbeitungseinrichtung 50 ausgelesen - Bezugszeichen 62.

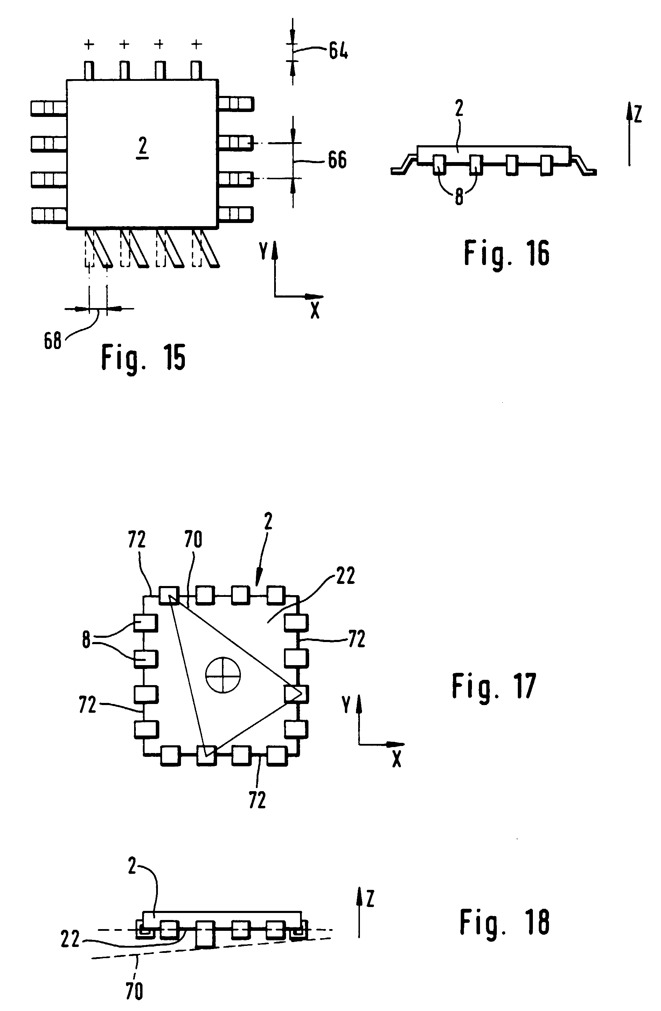

In den Fig. 15 und 16 ist der Bauelementetyp Gull-Wing, und in den Fig. 17 und 18 der Bauelementetyp J-Lead dargestellt. Neben diesen dargestellten Bauelementen können auch andere SMD-Bauelemente abgebildet und geprüft werden, wie etwa Bauelemente mit Ballpoint-Anschlüssen oder dergleichen. In Fig. 15 sind verschieden charakteristische Parameter zu ersehen, die mit dem erfindungsgemäßen Prüfsystem überprüft werden können; Beinchengruppenversatz (span) 64, Teilung (pitch) 66 und Position der Beinchen (head skew) 68.

Mittels der durch Kalibrierung ermittelten Transformationsmatrix können aus den einzelnen Meßwerten in den verschiedenen Einzelabbildungen die XYZ-Koordinaten beliebiger (durch das Fenster 30 sichtbarer) Punkte auf dem Bauelement 2 ermittelt werden. Aufgrund dieser Verfahren kann aus den Ergebnissen der Einzelansichten 2-i die Aufsetzfläche 70 (Fig. 17 und 18) des Bauelementes 2 berechnet werden. Anschließend wird für jedes Beinchen 8 der Abstand zur Aufsetzfläche 70 berechnet und mit einem Toleranz-Wert verglichen. Zur Bestimmung des Abstandes der Aufsetzfläche 70 zur Gehäuse-Unterkante 72 wird seitenweise.die Gehäusekante 72 detektiert. Aus allen vier Kanten wird die Fläche der Bauelemente- bzw. Gehäuse-Unterkante 22 errechnet und danach der minimale Abstand zur Aufsetzfläche 70 bestimmt. Der Abstand wird mit einem Grenzwert verglichen. Optional kann mittels der zweiten CCD-Kamera 24 eine Pin-1-Kennung überprüft werden, soweit das Pin-1-Merkmal an der Unterseite 22 des Bauelementes 2 erkennbar ist.

Das Bauelement 2 hat die dreidimensionale Prüfung der Beinchen 8 dann bestanden, wenn
1. das von der Aufsetzfläche 70 am weitesten entfernte Beinchen 8 noch innerhalbe der Z-Toleranz liegt;
2. der Abstand zwischen Gehäuse-Unterkante und Aufsetzfläche innerhalb einer Toleranz liegt.

## Patentansprüche

1. Vorrichtung zum Abbilden eines dreidimensionalen Objekts (2), das sich in einem Abbildungsbereich (6) befindet, mit
einer Bilddarstellungseinrichtung (16, 24),
einer optischen Abbildungsanordnung (12) mit mehreren optischen Elementen (26),
die gleichzeitig Einzelabbildungen von wenigstens zwei unterschiedlichen Ansichten (2-i) des dreidimensionalen Objekts (2)
aus unterschiedlichen blickwinkeln
auf eine gemeinsame Bildfläche (21) der Bilddarstellungseinrichtung (16, 24) projiziert, und
einer Beleuchtungseinrichtung (14) zur kurzzeitigen Beleuchtung des dreidimensionalen Objektes (2), dadurch gekennzeichnet,
daß sich der Abbildungsbereich (6)
außerhalb von jeder Sichtlinie zwischen den einzelnen optischen Elementen (26) der optischen Abbildungsanordnung (12) und
außerhalb von jeder Sichtlinie zwischen der Beleuchtungseinrichtung (14) und den einzelnen optischen Elementen (26) der optischen Abbildungsanordnung (12)
befindet.

2. Vorrichtung nach Anspruch 1, dadurch gekennzeichnet, daß der Abbildungsbereich (6) außerhalb von jeder Sichtlinie zwischen der Beleuchtungseinrichtung (14), der Bilddarstellungseinrichtung (16, 24) und den einzelnen optischen Elementen (26) der optischen Abbildungsanordnung (12) angeordnet ist.

3. Vorrichtung nach Anspruch 1 oder 2, dadurch gekennzeichnet, daß die optische Abbildungsanordnung (12) eine Vielzahl von Spiegeln (26) als optische Elemente umfaßt, die derart in festgelegten Lagen und Abständen zueinander angeordnet sind, daß die wenigstens zwei Einzelabbildungen neben- bzw. untereinander auf der gemeinsamen Bildfläche erscheinen.

4. Vorrichtung nach einem der vorhergehenden Ansprüche, dadurch gekennzeichnet, daß der Strahlengang jeder Einzelabbildung, ausgehend von einer Abbildungsposition (7) im Abbildungsbereichs (6) bis zur gemeinsamen Bildfläche die gleiche Länge aufweist.

5. Vorrichtung nach einem der vorhergehenden Ansprüche, dadurch gekennzeichnet, daß die optische Abbildungsanordnung (12) und die Beleuchtungseinrichtung (14) in einem abgeschlossenen Gehäuse (10) untergebracht sind, welches ein Fenster (30) zur Beleuchtung und Abbildung des sich außerhalb des Gehäuses im Abbildungsbereich (6) befindenden Objekts (2) aufweist.

6. Vorrichtung nach Anspruch 5, dadurch gekennzeichnet, daß das Fenster (30) als trogförmige Vertiefung mit Bodenplatte (32) und Seitenwänden (31) in einer Oberfläche des Gehäuses (10) ausgebildet ist, und daß die Strahlengänge der einzelnen Ansichten die Seitenwände (31) im wesentlichen senkrecht durchsetzen.

7. Vorrichtung nach wenigstens einem der vorhergehenden Ansprüche, dadurch gekennzeichnet, daß die Beleuchtungsintervalle der Beleuchtungseinrichtung (14) im Bereich von einer Sekunde und darunter und insbesondere im Mikrosekundenbereich liegen.

8. Vorrichtung nach wenigstens einem der vorhergehenden Ansprüche, dadurch gekennzeichnet, daß die Beleuchtungseinrichtung (14) eine Mehrzahl von Einzellichtquellen (34) umfaßt, die in wenigstens zwei Beleuchtungsebenen in unterschiedlichen Abständen von dem Abbildungsbereich (6) angeordnet sind.

9. Vorrichtung nach Anspruch 8, dadurch gekennzeichnet, daß die Einzellichtquellen (34) in einer Beleuchtungsebene ringförmig angeordnet sind.

10. Vorrichtung nach Ansprüch 8 oder 9, dadurch gekennzeichnet, daß die Einzellichtquellen (34) in Gruppen zusammengefaßt sind, die jeweils gleich weit entfernt von dem Abbildungsbereich (6) bzw. der Abbildungsposition (7) angeordnet sind.

11. Vorrichtung nach wenigstens einem der vorhergehenden Ansprüche, dadurch gekennzeichnet, daß die Beleuchtungseinrichtung (14) Licht unterschiedlicher Wellenlängen, insbesondere im nahen Infrarotbereich, aussendet.

12. Vorrichtung nach wenigstens einem der vorhergehenden Ansprüche, dadurch gekennzeichnet, daß zur Ausfilterung von Fremd- bzw. Störlicht eine optische Filtereinrichtung vor die Bilddarstellungseinrichtung (16, 24) geschaltet ist.

13. Vorrichtung nach wenigstens einem der vorhergehenden Ansprüche, dadurch gekennzeichnet, daß die Bilddarstellungseinrichtung wenigstens einen ortsauflösenden opto-elektronischen Wandler umfaßt, vorzugsweise in Form einer CCD-Matrix-Kamera (16, 24).

14. Vorrichtung nach Anspruch 13, dadurch gekennzeichnet, daß der opto-elektronische Wandler bzw. die Kamera (16, 24) elektronisch auslös- bzw. triggerbar ist.

15. Vorrichtung nach einem der vorhergehenden Ansprüche, dadurch gekennzeichnet, daß das Objekt (2) ein elektronisches Bauelement mit Anschlüssen (8) ist, insbesondere ein SMD-Bauelement.

16. Vorrichtung nach wenigstens einem der vorhergehenden Ansprüche, gekennzeichnet durch eine Bildverarbeitungseinrichtung (50) zum Berechnen der Koordinaten von Bildpunkten des dreidimensionalen Objekts (2) aus den wenigstens zwei Einzelabbildungen.

17. Vorrichtung nach Anspruch 16, gekennzeichnet durch ein Kalibrierteil (42) zum Kalibrieren der Vorrichtung zum Abbilden und Ausmessen eines dreidimensionalen Objekts, wobei das Kalibrierteil (42) aufweist:
eine planparallele Platte aus einem formstabilen Material, insbesondere Glas, mit einer Oberseite und einer Unterseite,
ein Markierungsmuster (44) auf einer der beiden Seiten der planparallelen Platte, und
eine Befestigungseinrichtung (45, 46) zum reproduzierbaren Fixieren des Kalibrierteils (42) in unterschiedlichen Positionen im Abbildungsbereich.

18. Vorrichtung nach Anspruch 17, dadurch gekennzeichnet, daß die Markierungsmuster (44) eingeätzt sind.

19. Vorrichtung nach Anspruch 17 oder 18, dadurch gekennzeichnet, daß die Befestigungseinrichtung Mikrometerschrauben (46) umfaßt.

20. Verfahren zum Kalibrieren einer Vorrichtung nach einem der Ansprüche 16 bis 19, mit den Verfahrensschritten:
a) Anordnen des Kalibrierteils (42) im Abbildungsbereich (6) mit einem bestimmten Abstand von der optischen Abbildungsanordnung (12),
b) Ausmessen der räumlichen Lage der Markierungsmuster (44),
c) Wiederholen der Schritte a) und b) mit unterschiedlichen Abständen, und
d) Errechnen einer Transformationsmatrix aus den Meßdaten gemäß b), den bekannten Abmessungen der Markierungsmuster (44), ihrer Anordnung auf dem Kalibrierteil (42) und den durch die Befestigungseinrichtung (45, 46) des Kalibrierteils (42) festgelegten Abständen der Abbildungsanordnung (12) von dem Kalibrierteil (42).

21. Verfahren zum Überprüfen der Beschaffenheit von dreidimensionalen Objekten mit einer Vorrichtung nach einem der Ansprüche 1 bis 19, mit den Verfahrensschritten:
a) Bewegen des dreidimensionalen Objekts (2) durch den Abbildungsbereich (6) hindurch;
b) Kurzzeitiges Beleuchten des Objekts (2), wenn es sich im Abbildungsbereich (6) befindet; und
c) Gleichzeitiges Abbilden von wenigstens zwei unterschiedlichen Ansichten des Objekts (2) aus unterschiedlichen Blickwinkeln und Projizieren der wenigstens zwei Einzelabbildungen neben-bzw. untereinander auf einer gemeinsamen Bildfläche (21).

22. Verfahren nach Anspruch 21, gekennzeichnet durch die weiteren Verfahrensschritte:
d) Ausmessen der Position von unterschiedlichen Punkten auf der Oberfläche des dreidimensionalen Objekts (2); und
e) Berechnen der räumlichen Koordinaten der unterschiedlichen Punkte der Oberfläche des Objekts (2) auf der Basis der Meßdaten gemäß d).

## Claims

1. Apparatus for forming the image of a three-dimensional object (2) which is disposed in an imaging region (6), comprising:
an image representation means (16, 24),
an optical imaging arrangement (12) with a plurality of optical elements (26),
which simultaneously projects individual images of at least two different views (2-i) of the three-dimensional object (2)
from different viewing angles
on to a common image surface (21) of the image representation means (16, 24), and
a lighting means (14) for temporarily lighting the three-dimensional object (2),
characterised in that
the imaging region (6) is disposed
outside each line of sight between the individual optical elements (26) of the optical imaging arrangement (12) and
outside each line of sight between the lighting means (14) and the individual optical elements (26) of the optical imaging arrangement (12).

2. Apparatus according to claim 1 characterised in that the imaging region (6) is arranged outside each line of sight between the lighting means (14), the image representation means (16, 24) and the individual optical elements (26) of the optical imaging arrangement (12).

3. Apparatus according to claim 1 or claim 2 characterised in that the optical imaging arrangement (12) includes a plurality of mirrors (26) as optical elements, which are arranged at fixed positions and spacings from each other in such a way that the at least two individual images appear in juxtaposed or subjacent relationship on the common image surface.

4. Apparatus according to one of the preceding claims characterised in that the beam path of each individual image, starting from an imaging position (7) in the imaging region (6) to the common image surface, is of the same length.

5. Apparatus according to one of the preceding claims characterised in that the optical imaging arrangement (12) and the lighting means (14) are disposed in a closed housing (10) having a window (30) for lighting and forming the image of the object (2) which is disposed outside the housing in the imaging region (6).

6. Apparatus according to claim 5 characterised in that the window (30) is in the form of a trough-shaped depression with bottom plate (32) and side walls (31) in a surface of the housing (10) and that the beam paths of the individual views pass substantially perpendicularly through the side walls (31).

7. Apparatus according to at least one of the preceding claims characterised in that the lighting intervals of the lighting means (14) are in the region of a second and below and in particular in the microsecond range.

8. Apparatus according to at least one of the preceding claims characterised in that the lighting means (14) includes a multiplicity of individual light sources (34) which are arranged in at least two lighting planes at different spacings from the imaging region (6).

9. Apparatus according to claim 8 characterised in that the individual light sources (34) are arranged in an annular configuration in a lighting plane.

10. Apparatus according to claim 8 or claim 9 characterised in that the individual light sources (34) are combined together in groups which are each arranged equally distant from the imaging region (6) or the imaging position (7).

11. Apparatus according to at least one of the preceding claims characterised in that the lighting means (14) emits light of different wavelengths, in particular in the near infra-red range.

12. Apparatus according to at least one of the preceding claims characterised in that an optical filter device is disposed in front of the image representation means (16, 24) for filtering out extraneous or interference light.

13. Apparatus according to at least one of the preceding claims characterised in that the image representation means includes at least one location-resolving opto-electronic transducer, preferably in the form of a CCD-matrix camera (16, 24).

14. Apparatus according to claim 13 characterised in that the opto-electronic transducer or the camera (16, 24) can be electronically tripped or triggered.

15. Apparatus according to one of the preceding claims characterised in that the object (2) is an electronic component with terminals (8), in particular an SMD-component.

16. Apparatus according to at least one of the preceding claims characterised by an image processing means (50) for computing the co-ordinates of pixels of the three-dimensional object (2) from the at least two individual images.

17. Apparatus according to claim 16 characterised by a calibration portion (42) for calibration of the apparatus for forming the image of and measuring a three-dimensional object, wherein the calibration portion (42) has:
a plane-parallel plate comprising a material which is stable in respect of shape, in particular glass, with a top side and an underside,
a marking pattern (44) on one of the two sides of the plane-parallel plate, and
a fixing means (45, 46) for reproducible fixing of the calibration portion (42) in different positions in the imaging region.

18. Apparatus according to claim 17 characterised in that the marking pattern (44) is etched in.

19. Apparatus according to claim 17 or claim 18 characterised in that the fixing means includes micrometer screws (46).

20. A method of calibrating an apparatus according to one of claims 16 to 19 comprising the method steps:
a) arranging the calibration portion (42) in the imaging region (6) at a given spacing from the optical imaging arrangement (12),
b) measuring the spatial position of the marking pattern (44),
c) repeating steps a) and b) at different spacings, and
d) calculating a transformation matrix from the measurement data in accordance with b), the known dimensions of the marking pattern (44), the arrangement thereof on the calibration portion (42) and the spacings of the imaging arrangement (12) from the calibration portion (42), which spacings are fixed by the fixing means (45, 46) of the calibration portion (42).

21. A method of checking the nature of three-dimensional objects with an apparatus according to one of claims 1 to 19, comprising the method steps:
a) moving the three-dimensional object (2) through the imaging region (6);
b) temporarily lighting the object (2) when it is in the imaging region (6); and
c) simultaneously forming the image of at least two different views of the object (2) from different viewing angles and projecting the at least two individual images in juxtaposed or subjacent relationship on to a common image surface (21).

22. A method according to claim 21 characterised by the further method steps:
d) measuring the position of different points on the surface of the three-dimensional object (2); and
e) calculating the spatial co-ordinates of the different points of the surface of the object (2) on the basis of the measurement data in accordance with d).

## Revendications

1. Dispositif en vue de la formation de l'image d'un objet tridimensionnel (2), qui se trouve dans un domaine de formation d'image, comportant
un dispositif de représentation d'image (16, 24),
un dispositif de formation d'image optique (12) équipé de plusieurs éléments optiques (26), qui projette simultanément des images distinctes d'au moins deux élévations différentes (2-i) de l'objet tridimensionnel (2) à partir d'angles de visée différents sur une surface d'image commune (21) du dispositif de représentation d'image (16, 24), et
un dispositif d'éclairement (14) en vue de l'éclairement temporaire de l'objet tridimensionnel (2),
caractérisé en ce que le domaine de formation d'image (6) se trouve à l'extérieur de chaque ligne de vue entre les différents éléments optiques (26) du dispositif de formation d'image optique (12) et à l'extérieur de chaque ligne de vue entre le dispositif d'éclairement (14) et les différents éléments optiques (26) du dispositif de formation d'image optique (12).

2. Dispositif selon la revendication 1, caractérisé en ce que le domaine de formation d'image (6) est disposé à l'extérieur de chaque ligne de visée entre le dispositif d'éclairement (14), le dispositif de représentation d'image (16, 24) et les différents éléments optiques (26) du dispositif de formation d'image optique (12).

3. Dispositif selon la revendication 1 ou 2, caractérisé en ce que le dispositif de formation d'image optique (12) comprend une pluralité de miroirs (26) en tant qu'éléments optiques, qui sont disposés en des positions et à des écartements fixes les uns des autres, de telle sorte que les au moins deux images distinctes apparaissent juxtaposées ou superposées sur la surface de formation d'image commune.

4. Dispositif selon l'une quelconque des revendications précédentes, caractérisé en ce que le trajet des rayons de chaque image distincte, en partant d'une position de formation d'image (7) dans le domaine de formation d'image (6) jusqu'à la surface commune d'image présente la même longueur.

5. Dispositif selon l'une quelconque des revendications précédentes, caractérisé en ce que le dispositif de formation d'image optique (12) et le dispositif d'éclairement (14) sont disposés dans un boîtier clos (10), qui présente une fenêtre (30) en vue de l'éclairement et de la formation d'image de l'objet (2) se trouvant à l'extérieur du boîtier dans le domaine de formation d'image (6).

6. Dispositif selon la revendication 5, caractérisé en ce que la fenêtre (30) est réalisée sous la forme d'une cavité sous forme de bac avec une plaque de fond (32) et des parois latérales (31) dans une surface du boîtier (10), et en ce que les trajets des rayons des différentes élévations traversent les parois latérales (31) sensiblement normalement.

7. Dispositif selon au moins l'une des revendications précédentes, caractérisé en ce que les intervalles d'éclairement du dispositif d'éclairement (14) sont de l'ordre d'une seconde et moins et en particulier de l'ordre de la microseconde.

8. Dispositif selon au moins une des revendications précédentes, caractérisé en ce que le dispositif d'éclairement (14) comprend une pluralité de sources lumineuses distinctes (34), qui sont disposées dans au moins deux plans d'éclairement à des écartements différents du domaine de formation d'image (6).

9. Dispositif selon la revendication 8, caractérisé en ce que les différentes sources lumineuses (34) sont disposées annulairement dans un plan d'éclairement.

10. Dispositif selon la revendication 8 ou 9, caractérisé en ce que les différentes sources lumineuses (34) sont réunies en groupes, qui sont disposés à écartement identique du domaine de formation d'image (6) ou de la position de formation d'image (7).

11. Dispositif selon au moins une des revendications précédentes, caractérisé en ce que le dispositif d'éclairement (14) rayonne une lumière de longueurs d'onde différentes, en particulier dans le proche infrarouge.

12. Dispositif selon au moins une des revendications précédentes, caractérisé en ce qu'en vue du filtrage de lumière étrangère ou parasite, un dispositif de filtrage optique est disposé en amont du dispositif de représentation d'image (16, 24).

13. Dispositif selon au moins une des revendications précédentes, caractérisé en ce que le dispositif de représentation d'image comprend au moins un convertisseur opto-électronique à définition fixe, de préférence, sous la forme d'une caméra à matrice CCD (16, 24).

14. Dispositif selon la revendication 13, caractérisé en ce que le convertisseur opto-électronique ou la caméra (16, 24) peut être déclenché électroniquement.

15. Dispositif selon l'une quelconque des revendications précédentes, caractérisé en ce que l'objet (2) est un composant électronique équipé de bornes (8), en particulier un composant CMS.

16. Dispositif selon au moins une des revendications précédentes, caractérisé par un dispositif de traitement d'image (50) en vue du calcul des coordonnées de points d'image de l'objet tridimensionnel (2) à partir d'au moins deux images distinctes.

17. Dispositif selon la revendication 16, caractérisé par une partie d'étalonnage (42) en vue de l'étalonnage du dispositif de formation d'image et de dimensionnement d'un objet tridimensionnel, la partie d'étalonnage (42) comportant :
une plaque à faces planes et parallèles en un matériau de forme stable, en particulier en verre avec un côté supérieur et un côté inférieur,
un motif de repères (44) sur l'un des deux côtés de la plaque à faces planes et parallèles, et
un dispositif de fixation (45, 46) en vue de la fixation reproductible de la partie d'étalonnage (42) en différentes positions dans le domaine de formation d'image.

18. Dispositif selon la revendication 17, caractérisé en ce que les motifs de repères (44) sont gravés.

19. Dispositif selon la revendication 17 ou 18, caractérisé en ce que le dispositif de fixation comprend des vis micrométriques (46).

20. Procédé d'étalonnage d'un dispositif selon l'une quelconque des revendications 16 à 19, comportant les étapes consistant à :
a) disposer la partie d'étalonnage (42) dans le domaine de formation d'image (6) à un espacement déterminé du dispositif de formation d'image optique (12),
b) mesurer la position spatiale du motif de repères (44),
c) répéter les étapes a) et b) avec des espacements différents et
d) calculer une matrice de transformation à partir des données de mesure selon b), les dimensions connues du motif de repères (44), de leur disposition sur la partie d'étalonnage (42) et des écarts déterminés par le dispositif de fixation (45, 46) de la partie d'étalonnage (42) du dispositif de formation d'image (12) de la partie d'étalonnage (42).

21. Procédé de vérification de la nature d'objets tridimensionnels à l'aide d'un dispositif selon l'une des revendications 1 à 19, comportant les étapes consistant à :
a) déplacer l'objet tridimensionnel (2) à travers le domaine de formation d'image (6);
b) éclairer temporairement l'objet (2), lorsqu'il se trouve dans le domaine de formation d'image (6); et
c) former simultanément des images d'au moins deux élévations différentes de l'objet (2) à partir d'angles de visée différents et projeter au moins deux images distinctes juxtaposées ou superposées sur une surface d'image commune (21).

22. Procédé selon la revendication 21, caractérisé par les étapes de procédé suivantes:
d) mesure de la position de différents points sur la surface de l'objet tridimensionnel (2); et
e) calcul des coordonnées spatiales des différents points de la surface de l'objet (2) en fonction des données de mesure selon d).
